# EUROPEAN PATENT APPLICATION

(11) **EP 1 465 320 A2**
(43) Date of publication of application: **06.10.2004**
(21) Application number: 04007881.8
(22) Date of filing: 01.04.2004
(51) Int. Cl.: H02J 13/00

(54) **Method and system for the automatic testing of electric equipments, in particular household appliances, and apparatus adapted for said method**

(30) Priority: 01.04.2003 IT TO20030252
(71) Applicant: WRAP S.p.A., 60044 Fabriano (Ancona) (IT)
(72) Inventor: Aisa, Valerio, 60044 Fabriano (AN) (IT)
(74) Representative: Dini, Roberto, Dr. Ing.

(57) **Abstract**

System for automatic testing during production of the operation and/or performance of an electric appliance (10) having at least a microcontroller (32) on board, characterized in that the test on the operation and/or performance of said electric appliance (10) is executed through the electric supply cable (15) of the electric appliance (10), which exchanges data and/or information with a test unit (17, 20) through an electric power modulation between said electric appliance (10) and said test unit (17, 20) and/or vice-versa; the system is also characterized in that said test unit comprises a monitoring device (20) operating on request of a main control system (17).

## Description

### State of the art and problem to be solved

The assembly process of electric appliances, in particular household appliances, is typically concluded with a test phase to check both the operation and/or performance of the electric appliance, such as the observance of the electric safety regulations and complete operation of each product before its packaging. A likely defective product is sent to an appropriate repair station and then submitted anew to a test procedure.

The target of the test systems usually adopted in modern manufacturing plants of electric appliances, in particular household appliances, is to reach utmost test efficiency in the shortest time possible, so as to warrant a high quality of the result at a minimum cost. This is obtained by means of sophisticated automatic test equipment, which usually differ according to the various lines of products and are managed by an appropriate computerized supervision system.

However, besides being very expensive, these test systems often fail to actually warrant a complete check of all possible failures of a product just assembled; moreover, some times they request too long test times and consequent high costs, as it happens for the testing of refrigerating appliances, such as refrigerators, freezers, environment air-conditioning system, etc. Moreover, probes and detecting instruments are needed in order to perform the test, which have to be introduced inside the appliance or co-operate with it to obtain the data required for executing the operation test and evaluate whether the performances of the appliance complies with the rated or theoretical ones.

In order to warrant utmost completeness of the test, it would be appropriate to have the products to be tested, managed by a digital control system placed on board of the electric appliance, being able to communicate with the test system itself. In this instance, the test system is actually able to verify the operation of each electric component, such as sensors, resistors for the heating, compressors, motors, electrovalves, fans, pumps, lamps, etc., through the "cooperation" of the product itself under test

Following the recent introduction of electric appliances, in particular household appliances, equipped with digital control systems on board, several test systems have already been developed, which ensure a direct dialog with the products under test. These known test systems are used, for instance, by the major manufacturers of digital controlled household appliances; however, for the time being these systems exclusively applied to high and/or very high class products, since they require appropriate communicating means on board of the products themselves (serial communication lines, infrared optical systems, ultrasound systems, radio-frequency systems, power line communication systems), the cost of which cannot be borne by medium or low class products, which represent anyway the great majority of the present production of household appliances.

Other test systems for refrigerating appliances are also known, which can shorten test times with the help of temperature detecting systems making use of non invasive techniques, such as infrared telecameras which allow for the monitoring of temperature distribution in the outer portions of the product with time. However, these highly expensive systems require sophisticated algorithms for the analysis of the images and do not guarantee a complete check of all the possible failures of the tested product.

It is the object of the present invention to solve the above drawbacks and provide a low-cost test system and method for performing a very wide check of the performance and possible failures of an electric appliance, in particular a household appliance, such to be used for testing any products, including low class products.

This aim is reached providing a test system and method incorporating the features described in the annexed claims, which are intended to all effects as an integral part of the description herein.

### Description of the Invention

The object of the present invention consists of a low-cost test system for executing a fast exhaustive check of the performance and possible failures of an electric appliance, in particular a household appliance, as well as of a relevant non invasive test method based on a direct dialog (i.e. requiring no specific wiring) between the test apparatus and the digital control system of the electric appliance under test which, in a preferred embodiment, does not require application of any sensors or measuring instruments on board of the electric appliance itself.

Such a dialog is based on a peer-to-peer communication technique as described in the patent application PCT/IB01/00548 (International Publication Number: WO 02/21664 Al), according to which any electric appliance can exchange information with the outer environment by means of its power supply cable, without using expensive conventional communicating means (serial lines, infrared systems, radio-frequency systems, power line carrier communication systems, etc.), provided it is equipped with a digital control system, which can be very simple and thus low cost.

The object of the present invention, advantageously making use of the above communication technique, is described in detail through the following set of figures provided by way of non limiting example, wherein:
- Fig. 1 shows a first embodiment of the test system according to the present invention;
- Fig. 1a shows a second embodiment of the same test system;
- Fig. 2 shows the block diagram of a monitoring device used in the test system of the figures 1 and 1a;
- Fig. 3 shows the block diagram of the significant section for the purposes of the invention of the electronic control system on board of the electric appliance under test;
- Fig. 4 describes the procedure for transmitting the data from the monitoring device of Figure 2 to the electric appliance of Figure 3;
- Fig. 5 describes the procedure for transmitting the data in the opposite direction, i.e. from the electric appliance to the monitoring device;
- Fig. 6 shows a particularly advantageous application of the present invention for testing refrigerating appliances;
- Fig. 7 finally shows the flow diagram of the test system according to the present invention with reference to the preferred application represented in Figure 6.

Before illustrating the test system according to the present invention, it is convenient to describe more in detail the peer-to-peer communication technique previously mentioned.

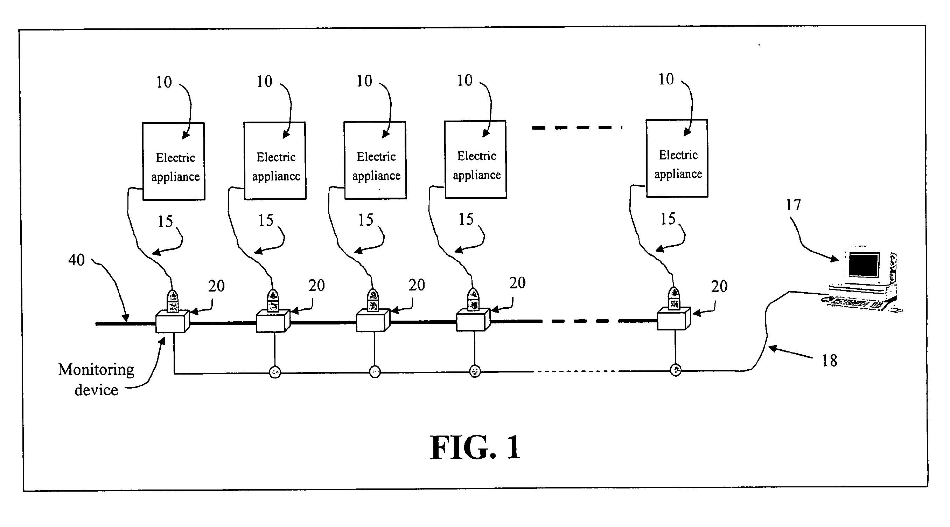

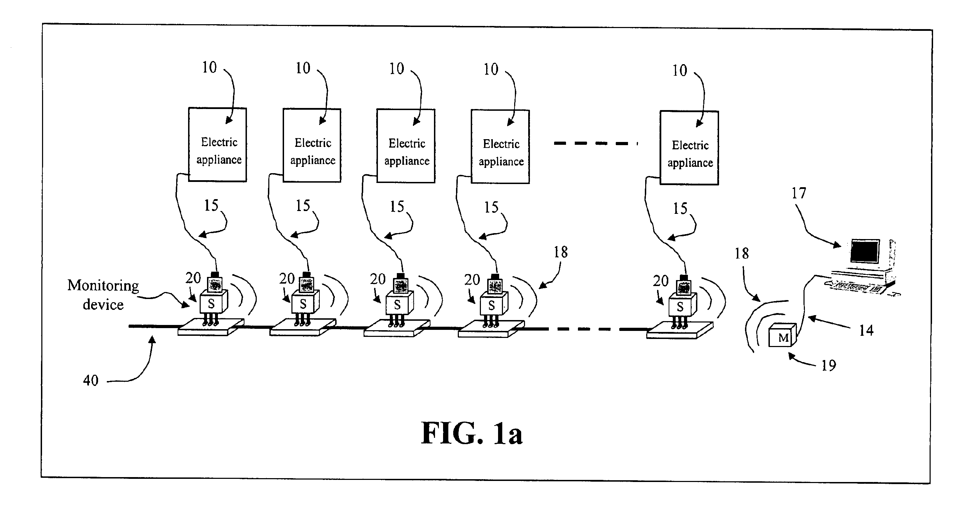

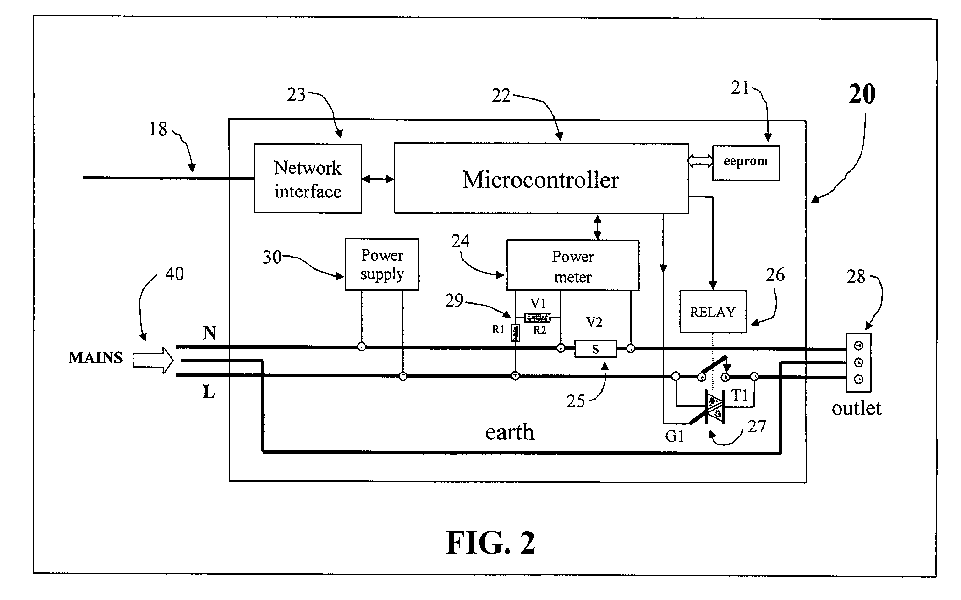

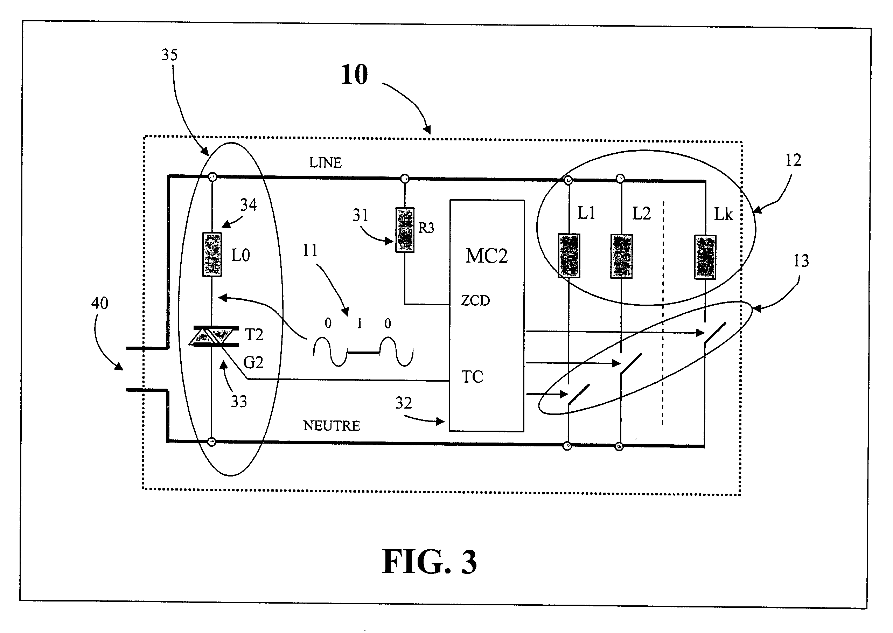

Based on the above communication technique, an electric appliance (10, fig. 1) can exchange information with an external monitoring device (20, fig. 1) located between the electric appliance itself and its relevant power socket, according to the following two procedures:
1. Transmission of information from the electric appliance (10) to the monitoring device (20) occurs through power absorptions by the electric appliance (10) associated to a sequence of mains cycles appropriately coded; these power absorptions are measured on receipt, cycle by cycle, by an appropriate power meter (24, fig. 2) housed inside the monitoring device (20) and subsequently decoded by a microcontroller (22, fig. 2).
2. Transmission of information from the monitoring device (20) to the electric appliance (10) occurs by means of short blackouts appropriately coded of the mains voltage, which are performed by means of a triac (27, fig. 2); the duration of such blackouts is measured and decoded on receipt by a microcontroller (32, fig. 3) associated to the control system of the electric appliance (10).

Thus a bi-directional peer-to-peer data transmission between an electric appliance (10) and an external monitoring device (20) is obtained at very low cost, with no need for the electric appliance to have inside an expensive communication node provided with an appropriate protocol for network connection. At any rate, network connection of the electric appliance (10) is warranted indirectly through a communication node (23, fig. 2) inside the monitoring device (20).

The above communication technique has the great advantage of requiring neither additional costs for the electric appliance (10), which would not be acceptable for this line of products, nor the need to choose a determined network protocol during production; however, all of it without giving up the opportunity of exchanging information with an external communication network, including the test system of the electric appliances delivered from the production line, being such a communication network reached indirectly through the monitoring device (20).

### Architecture of the test system according to the present invention

The architecture of the test system according to the present invention, as described in the Figures 1 and 1a, shows a set of electric appliances (10), each one of them connected through their own supply cable (15) to the mains (40) by means of an appropriate monitoring system (20) appropriately connected to the communication network (18) to which a main control device (17), represented for instance by a Personal Computer, is also connected. The communication network (18) represented in Figure 1 is of the wired type, such as an RS-485 network or analogous, whereas the network represented in Figure 1a is a wireless one, such as a radio-frequency network. Analogously, the monitoring device (20) shown in Figure 1 is a fixed device housed inside an appropriate power socket, whereas the one illustrated in Figure 1a is a movable one represented by an adaptor interlaying between the power socket and the supply cable of the electric appliance (10). The main controller (17) performs a master function for the monitoring devices (20), sending them appropriate instructions and providing for receiving and processing the information picked up by the last ones. The above information are partially generated by each monitoring device (20) and partially supplied by each electric appliance (10) through its supply cable, using the low cost communication technique described in the patent application PCT/IB01/00548 previously mentioned.

The monitoring device (20) described in Figure 2 consists of the following function blocks:
- Power supply block (30) for supplying the appropriate stabilized direct voltage required by each active element of the system;
- Control and processing block represented by the microcontroller (22) and nonvolatile memory (21);
- A block for receiving the information sent by the electric appliance (10), represented by the power meter (24) for detecting the value of the supply voltage through the resistive divider (29) and the value of the current by means of the shunt resistor (25); the above information, coded by the electric appliance (10) through power absorptions synchronized with the mains frequency, are read by the power meter through power measures synchronized in an analogous way;
- A block for transmitting the information sent by the monitoring device (20) to the electric appliance (10) through short blackouts of the mains voltage; these blackouts are performed by means of a triac (27) controlled by the microcontroller (22), while the normally closed contact of the relay (26) remains momentarily open to let the above triac operate;
- A block for managing the mains supply to the electric appliance (10) through the power socket (28); such a management is performed by the microcontroller (22) through the relay (26) having a normally closed contact connected in parallel to the triac (27);
- A block (23) for network connection of the monitoring device (20), which represents the communication node for connecting such a device to the transmission element (18), which may be a wired or wireless one (radio-frequency).

The control system housed inside the electric appliance (10) is schematically represented in the Figure 3 highlighting the function blocks forming it:
- A control and processing block is represented by the microcontroller (32), for managing the various electric loads (12) through appropriate controlled switches (13) represented by relays or triacs;
- A block (35) for transmitting the information to the monitoring device (20) represented by the triac (33) which, under control of the microcontroller (32), manages through the resistive load (34) the power absorptions synchronized with the mains frequency to which the information themselves are associated;
- A block for receiving the information sent from the monitoring device (20) is represented by the resistor (31) through which the microcontroller (32) detects the zero passage of the mains voltage (40): the above information, indicated in Figure 3 with reference number (11), are detected measuring the displacement of the zero passage of said voltage caused by the mains blackouts produced by the monitoring device (20).

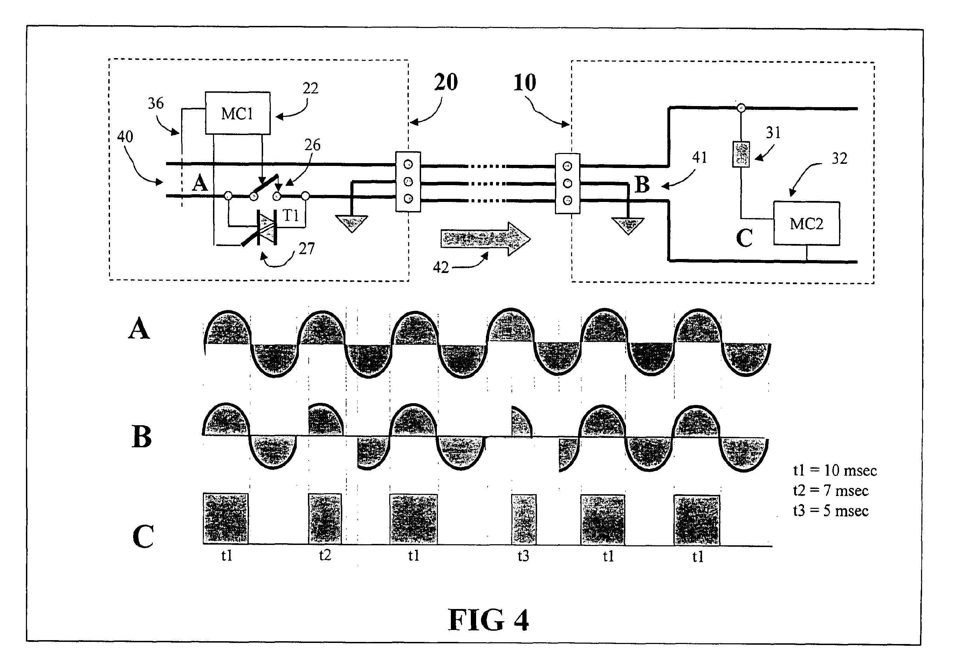

The coding procedure of the information sent from the monitoring device (20) to the electric appliance (10) is graphically described in Figure 4, where the three waveforms A, B and C represent the mains voltage (40) supplying the monitoring device (20), the mains voltage (41) supplying the electric appliance (10) and containing the mains holes impressed by the monitoring device (20) through the triac (27) and, finally, the time intervals elapsing between the consecutive zero passages of the positive wave of the mains voltage (41) supplying the electric appliance (10), respectively. The different length of these time intervals depends on the quantity of the corresponding blackout of the mains voltage and contains the coded information transmitted from the monitoring device (20) to the electric appliance (10). The measure of the above time intervals is performed by the microcontroller (32) contained on board of the electric appliance (10) through an appropriate inner timer: based on the measure performed by this timer, the microcontroller (32) will decode the binary information contained in every time interval. In the assumption, for instance, of a 4 bit coding (nibble), the interval t1=10 msec would correspond to the lack of a mains hole, the interval t2=7 msec may correspond to a "0000" nibble and, finally, the interval t3=5 msec may correspond to a "1111" nibble, assuming that the interval t2-t3=2 msec (i.e. 2000 microseconds) is split in 16 steps of 125 microseconds each (2000 : 16 = 125).

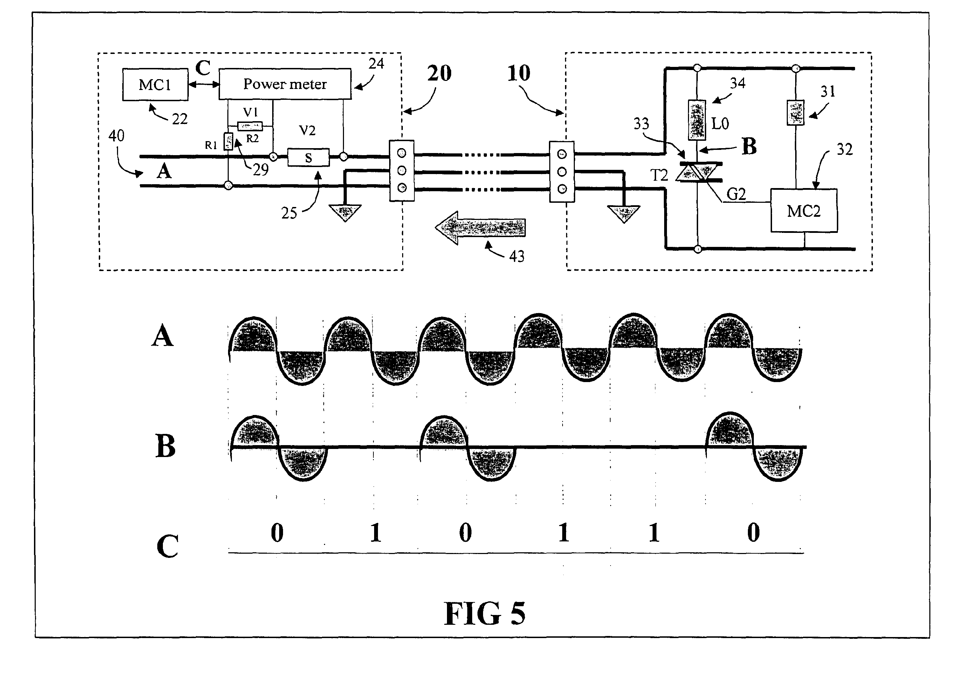

The coding procedure of the information sent by the electric appliance (10) to the monitoring device (20) is graphically described in Figure 5, where the three waveforms A, B and C represent the mains voltage (40) supplying both the monitoring device (20) and the electric appliance (10), the voltage to the terminals of the triac (33) driving the resistive load (34) and the binary coding associated to the power absorptions of such a resistive load, respectively: a "logic one" can be associated e.g. to the power absorption of the load (34) in the frame of a whole mains cycle, whereas a "logic zero" is consequently associated to the lack of said absorption.

### Test method according to the present invention

Provided a test system for electric appliances (10), in particular household appliances, having the architecture of the type described above, the method for performing the test according to the present invention is managed by the main control system (17) according to the following steps:
Step 1. Supplying power to the electric appliance (10) under test by the monitoring device (20) on request of the main control system (17).
Step 2. Measuring the power absorptions of the single electric loads associated to the electric appliance (10) under test, on request of the main control system (17). This operation is performed by the monitoring device (20) through the transmission to the electric appliance (10) of appropriate sequences of activation instructions of its electric loads (12), to which the measures of the relevant power absorptions, executed through the power meter (24) fitted on the monitoring device, are made to correspond. These measures are stored from time to time inside the nonvolatile memory (21).
Step 3. Acquisition of the quantities monitored by the various sensors inside the electric appliance (10) under test, on request of the main control system (17). This acquisition is performed by the monitoring device (20), which receives the above information directly from the electric appliance (10) and stores them in its own nonvolatile memory (21).
Step 4. Deactivation of the electric appliance (10) and transmission of the information acquired during the test of the electric appliance itself by the relevant monitoring device (20) to the main control system (17).
Step 5. Analysis of the information received through the main control system (17). On the basis of such an analysis, the main control system (17) is going to formulate the test diagnose of the electric appliance (10) under test.

The most prominent feature of the present invention is represented by the fact that the electric appliance (10) is tested just connecting it to the power socket of the test system, utilizing the electronics already on board normally used for other purposes; in other words, the test process can be totally automated through mechanical insertion of the plug of the power supply cable of the electric appliance in the power socket of the test system.

### Example of a highly advantageous application according to the present invention

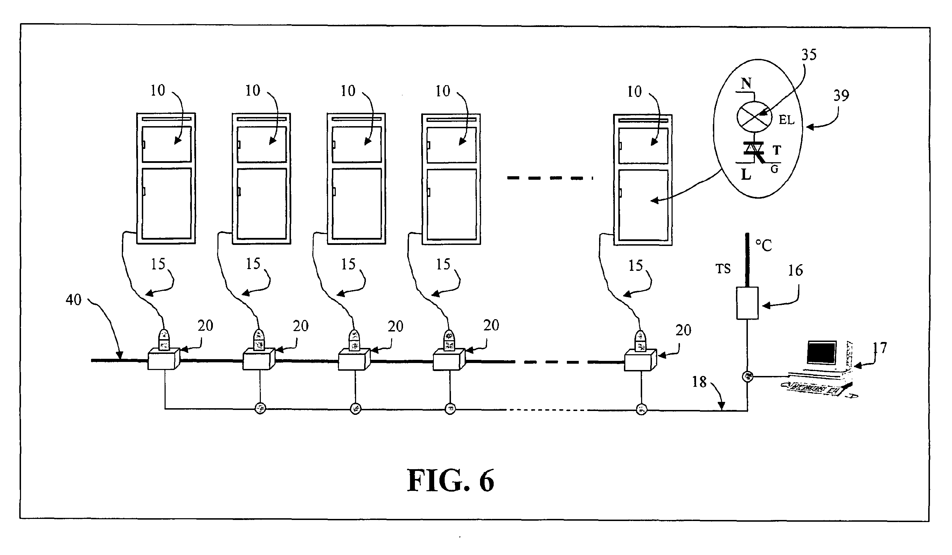

Figure 6 is illustrating an example of a highly advantageous application, where the electric appliance (10) is represented by a household refrigerator. However, the same application can be adopted for any other refrigerating apparatus, such as a freezer or an environment air conditioner.

In this instance, the most important benefit which can be obtained according to the present invention, besides ensuring a complete test performance and very low cost of the test system, is represented in particular by a drastic shortening of the test time; the present test times, in the order of 1,5 - 2 hours, can be actually reduced to 10 - 15 minutes, with no use of sophisticated test instrumentations, such as infrared telecamera systems or insertion of special probes inside the appliance.

In the instance of a household refrigerator, the same lamp (35) typically present inside the refrigerating compartment, can also be used as a resistive load (34), required for data transmission from the electric appliance (10) to the monitoring device (20); thus avoiding any cost increase for the control system electronics of the household appliance.

With respect to the general architecture of Figures 1 and 1a, it should be noticed that the one represented in Figure 6 has an additional environment temperature sensor (16) connected to the main control system (17), being used for verifying the performance of the temperature sensors (one or more) located inside the refrigerator which, on the first activation of the product, should all detect a temperature close to the environment temperature of the manufacturing factory, since they are delivered directly from the assembly line and have not been supplied yet.

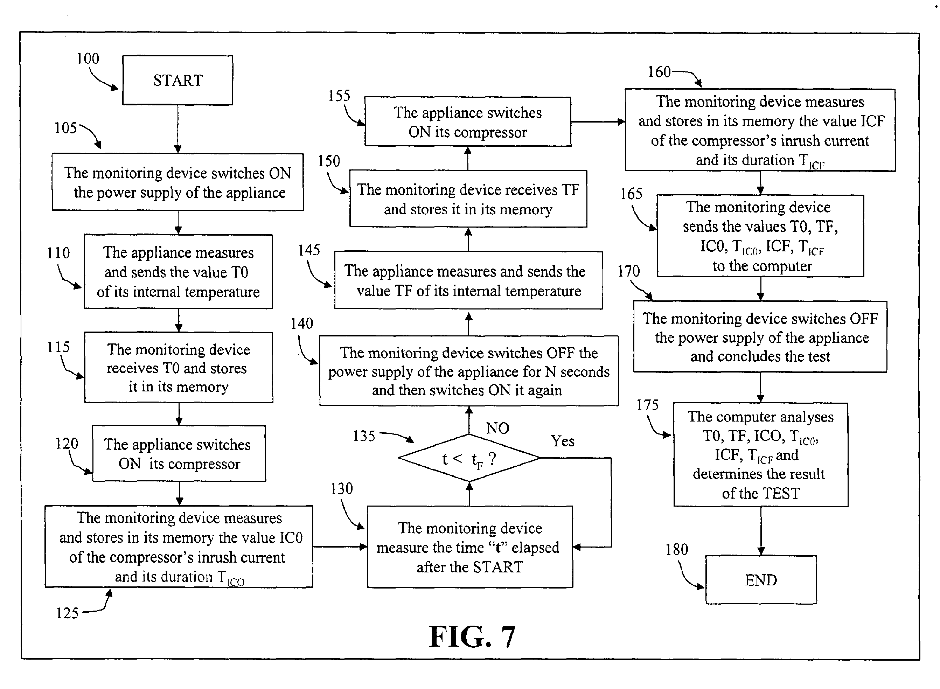

An example of test sequence for household refrigerators according to the present invention is described in the flow diagram of Figure 7, where for simplicity's sake it is assumed that each refrigerator is provided with only one temperature sensor. The test starts from the starting block (100) activating the voltage supply of the product under test, through the block (105). Once the power-on operation is concluded, the control goes on to block (110), in which the refrigerator measures the temperature value detected by its inner sensor and sends it to the monitoring device (20) using the lamp (35) as a resistive load for data transmission through power absorptions. Then the control goes on to block (115), in which the monitoring device (20) receives and stores the data sent by the refrigerator (10) and transfers the control to the subsequent block (120), in which the refrigerator activates its own compressor on request of the monitoring device (20). As soon as the compressor is activated, the control goes on to block (125), where the monitoring device (20) will measure and store in its own memory (21) the value of the compressor's inrush current and duration of the starting transitory; then the control is transferred to block (130). Along with the test block (135), this block (130) checks whether the time elapsed from the activation of the compressor is less than a preset value t_{F} or not: in the affirmative case, one should wait; in the negative case (reaching time t_{F}), the control is transferred on the contrary to the block (140), in which the monitoring device (20) stops supplying the refrigerator for a number N of seconds and then restores it again, transferring the control to the block (145). In this block, the refrigerator (10) sends the temperature value presently detected by its inner sensor to the monitoring device (20) and transfers the control to the subsequent block (150). The monitoring device (20) receives and stores in its nonvolatile memory (21) the temperature value sent by the refrigerator (10), then transfers the control to the block (155); in line with this block the refrigerator activates the compressor again and transfers the control to the block (160). In line with the block (160), the monitoring device (20) measures and stores the value of the compressor's inrush current and duration of the starting transitory in its memory (21), then transfers the control to the block (165). At block (165), the monitoring device (20) sends to the main control system (17) both the values of the temperature, the compressor's inrush current and duration of the starting transitory previously stored in its memory (21), then the control is transferred to the block (170). In line with this block the monitoring device (20) stops supplying the refrigerator actually concluding the test, and transfers the control to the block (175), in which the main control system (17) is going to process the information data received from the monitoring device (20) and determine the test result; the control will be definitively transferred to the block (180), which terminates the test process of the refrigerator (10).

Following the result of a combined analysis of the values of the operation parameters of the refrigerator received through the monitoring device (20), the main control system (17) can issue a judgment on the operating level and/or performance of every appliance under test.

From the above description the advantages of the present invention previously highlighted in terms of reduction of test costs and result safety are clearly evident.

It is obvious that many changes are possible to the examples described above, without exiting from the scope of protection requested for the present invention. By way of example it is obvious that the means and materials described above can be replaced with other technical equivalent elements and that the products under test can pertain to the most various types, provided they are fitted with programmable electronics on board.

## Claims

1. A system for automatic testing during production of the operation and/or performance of an electric apparatus (10) having at least a microcontroller (32) on board, **characterized in that** the test of the operation and/or performance of said electric appliance (10) is performed through the electric supply cable (15) of said electric appliance (10), which exchanges data and/or information with a test unit (17, 20) through an electric power modulation between said electric appliance (10) and said test unit (17, 20) and/or vice-versa.

2. A system for testing an electric appliance (10), according to claim 1, **characterized in that** power supply to said electric appliance (10) under test is provided by a monitoring device (20) operating on request of a main control system (17).

3. A system for testing an electric appliance (10), according to claim 2, **characterized in that** said monitoring device (20) on request of the main control system (17) measures the power absorptions of the single electric loads associated to said electric appliance (10) under test, and that said monitoring device (20) performs the measures transmitting to the electric appliance (10) appropriate sequences of activation instructions of its electric loads (12), to which the measures of the relevant power absorptions executed through the power meter (24), fitted on the monitoring device (20), are made to correspond.

4. A system for testing an electric appliance (10), according to claim 3, **characterized in that** said measures are stored from time to time in a nonvolatile memory (21).

5. A system for testing an electric appliance (10), according to claim 3 or 4, **characterized in that** said monitoring device (20) on request of said main control system (17) acquires the quantities monitored by various sensors inside said electric appliance (10), and said acquisition is performed by said monitoring device (20), which receives the above information directly from said electric appliance (10) and stores them in a nonvolatile memory (21).

6. A system for testing an electric appliance (10), according to one or more of the previous claims, **characterized in that**, said electric appliance (10) on request of said main control system (17) is deactivated by the monitoring device (20) and the information acquired during the test of said electric appliance itself are sent to said main control system (17) by the relevant monitoring device (20).

7. A system for testing an electric appliance (10), according to claim 6, **characterized in that** said main control system (17) executes the analysis of the information received and on the basis of said analysis said main control system (17) is going to formulate the operation and/or performance diagnosis of the electric appliance (10) under test.

8. A system for testing an electric appliance (10), according to one or more of the previous claims, **characterized in that**, said control system of said electric appliance (10) comprises the following function blocks:
- A control and processing block represented by said microcontroller (32), for managing the various electric loads (12) through appropriate controlled switches (13), represented by relays or triacs;
- A block (35) for transmitting information to said monitoring device (20) represented in particular by a triac (33) which, under control of said microcontroller (32), manages, through the resistive load (34), the power absorptions synchronized with the mains frequency to which the information data themselves are associated;
- A block for receiving the information sent from said monitoring device (20) represented in particular by a resistor (31), through which said microcontroller (32) detects the zero passage of the mains voltage (40): said information being detected measuring the time displacement of the zero passage of said voltage caused by the mains blackouts produced by said monitoring device (20).

9. A system for testing an electric appliance (10), according to one or more of the claims from 2 to 8, **characterized in that** the monitoring device (20) comprises the following function blocks:
- A power supply block (30) for supplying the appropriate stabilized direct voltage required by each active element of the system;
- A control and processing block represented by a microcontroller (22) and nonvolatile memory (21);
- A block for receiving the information sent by the electric appliance (10), represented by a power meter (24) for detecting the value of the supply voltage through a resistive divider (29) and the value of the current by means of a shunt resistor (25); said information being coded by the electric appliance (10) through power absorptions synchronized with the mains frequency and being read by said power meter (24) through power measures synchronized in an analogous way;
- A block for transmitting the information sent by the monitoring device (20) to the electric appliance (10) through short blackouts of the mains voltage; said blackouts being performed in particular by means of a triac (27) controlled by said microcontroller (22), being the normally closed contact of the relay (26) momentarily open to let the above triac (27) operate;
- A block for managing mains supply to said electric appliance (10) through a power socket (28); such a management being performed by the microcontroller (22) through a relay (26) with a normally closed contact connected in parallel to said triac (27);
- A block (23) for network connection of said monitoring device (20), representing the communication node connecting such a device to said transmission element (18), which may be a wired or wireless one (radio-frequency).

10. An electric appliance (10), in particular a household appliance provided to be tested by the test system according to one or more of the previous claims, having the following function blocks:
- A control and processing block represented by said microcontroller (32), managing the various electric loads (12) through appropriate controlled switches (13), represented in particular by relays or triacs;
- A block (35) for transmitting the information to said monitoring device (20) represented in particular by a triac (33) which, under control of the microcontroller (32), manages, through the resistive load (34) in particular, the power absorptions synchronized with the mains frequency to which the information data themselves are associated;
- A block for receiving the information from said monitoring device (20) represented in particular by a resistor (31), through which said microcontroller (32) detects the zero passage of the mains voltage (40): said information being detected measuring the time displacement of the zero passage of said voltage caused by the mains blackouts produced by said monitoring device (20).

11. A method for testing during production the operation and/or performance of an electric appliance (10) having at least a microcontroller (32) on board, **characterized in that** the test of the operation and/or performance of said electric appliance (10) is performed through the electric supply cable (15) of said electric appliance (10), which exchanges data and/or information with a test unit (17, 20) through an electric power modulation between said electric appliance (10) and said test unit (17, 20) and/or vice-versa.

12. A method for testing during production the operation and/ or performance of an electric appliance (10) according to claim 11, **characterized by** the following steps:
a) Supplying power to said electric appliance (10) under test by said monitoring device (20), on request of the main control system (17).
b) Measuring the power absorptions of the single electric loads associated to the electric appliance (10) under test on request of the main control system (17), said operation being performed by said monitoring device (20) transmitting to the electric appliance (10) appropriate sequences of activation instructions of its electric loads (12), to which the measures of the relevant power absorptions executed through the power meter (24), fitted on the monitoring device, are made to correspond.
c) Storage of said measures from time to time inside a nonvolatile memory (21) housed inside said monitoring device.
d) Acquisition of the values of the quantities monitored by the various sensors located inside said electric appliance (10) under test, on request of the main control system (17), said acquisition being performed by said monitoring device (20), which receives said information directly from said electric appliance (10) and stores them in its own nonvolatile memory (21).
e) Deactivation of said electric appliance (10) and transmission of the information acquired during the test of said electric appliance by said relevant monitoring device (20) to said main control system (17).
f) Analysis by said main control system (17) of the information received by said monitoring device (20).
g) Formulation by said main control system (17) of the test diagnosis of said electric appliance (10) in terms of operation and/or performance.
